# EUROPÄISCHE PATENTANMELDUNG

(11) **EP 4 517 286 A1**
(43) Veröffentlichungstag der Anmeldung: **05.03.2025**
(21) Anmeldenummer: 23194309.3
(22) Anmeldetag: 30.08.2023
(51) Int. Cl.: G01K 11/06, G01K 3/00, G01K 1/02, H05K 1/02, H05K 3/12, H01H 85/046

(54) **TEMPERATUREREIGNIS-DETEKTIONSSTRUKTUR UND -VERFAHREN**

(71) Anmelder: Siemens Aktiengesellschaft, 80333 München (DE)
(72) Erfinder: Franke, Martin, 14089 Berlin (DE); Frühauf, Peter, 14612 Falkensee (DE); Strogies, Jörg, 14163 Berlin (DE)
(74) Vertreter: Siemens Patent Attorneys

(57) **Zusammenfassung**

Es wird ein Verfahren und eine Detektionsstruktur zur Erfassung eines Temperaturereignisses in einem elektrischen System vorgeschlagen. Mittels wenigstens einer Temperaturereignis-Detektionsstruktur (det) mit einem metallurgisch nicht benetzbaren Bereich (1) zwischen elektrischen Kontakten (4), welche Kontakte (4) vor einem zu erfassenden Temperaturereignis über einen Lotkörper (3) elektrisch verbunden sind (det_c) und welcher Lotkörper (3) während eines zu erfassenden Temperaturereignis aufschmilzt und sich dessen Lotvolumen derart von dem metallurgisch nicht benetzbaren Bereich (1) zurück zieht, dass es nach einem erfassten Temperaturereignis mehrere elektrisch voneinander getrennte Teillotkörper (3') ausbildet, können kostengünstig und systemintegriert, zuverlässig Übertemperaturereignisse erfasst werden. Die geschlossenen, unbelasteten Temperaturereignis-Detektionsstruktur(en) (det) werden realisiert durch Ausübung einer Formkontrolle während der Erstarrung des Lotvolumens zu einem Lotkörper (3), so dass der Lotkörper eine elektrische Verbindung zwischen wenigstens zwei elektrischen Kontakten (4) herstellt.

## Beschreibung

Die Erfindung betrifft ein Verfahren zur Erfassung eines Temperaturereignisses in einem elektrischen System sowie eine Temperaturereignis-Detektionsstruktur und ein Herstellungsverfahren für diese Temperaturereignis-Detektionsstruktur.

### Stand der Technik

Es gibt bereits heute eine zunehmende Bedeutung des Nachhaltigkeitsaspekts in einer Produktbewertung. Auf dem Markt der Elektronikprodukte ist zudem bereits mit einer Verknappung von Bauteilen, insbesondere aufgrund einer Verknappung von Rohstoffen, zu kämpfen. Man ist bestrebt, Elektronikprodukte bevorzugt in einem geschlossenen Kreislauf zu führen, um die Nachhaltigkeit der Produkte zu erhöhen. Bisherige Methoden zur Restlebensdauerabschätzung sind jedoch noch nicht zuverlässig genug.

Einer der Gründe für nur sehr unzureichende Lebensdauerabschätzungen ist der, dass zu wenige zuverlässige Felddaten für ein Elektronikprodukt nach dessen Rücklauf vorhanden sind. Felddaten können Aufschluss darüber geben, welchen Umweltbelastungen ein Elektronikprodukt während des Einsatzes ausgesetzt war. Insbesondere trägt ein Elektronikprodukt nach dem Feldrücklauf bisher keine Information mit sich, welchen Temperaturen es während des Einsatzes ausgesetzt war. Doch vor allem Übertemperaturereignisse können Elektronikprodukte schädigen und selbst bei noch anhaltender Funktion die Restlebensdauer beträchtlich reduzieren. Auch unvorhersehbare Fehlfunktionen können durch einmalige Übertemperaturereignisse hervorgerufen werden.

Bisher gibt es für die Detektion von Temperaturereignissen nur den Ansatz, Temperatursensoren zu verbauen. Ein derartiger Ansatz ist aber sehr aufwändig. Insbesondere die dafür notwendige Datenspeicherung ist sehr aufwändig. Außerdem ist die dafür notwendige Schaltungstechnik teuer und aufwändig und erfordert zusätzlichen Bauraum im elektronischen Produkt.

Auch Thermosicherungen sind bekannt, welche zwar kommerziell verfügbar jedoch teuer sind, typischerweise sehr viel Bauraum im elektronischen Produkt einnehmen und generell schwierig auf gewisse Systemeinheiten einsetzbar sind.

Ausgehend vom zuvor beschriebenen Stand der Technik liegt der Erfindung die Aufgabe zugrunde, ein Verfahren sowie eine Vorrichtung zur Durchführung des Verfahrens anzugeben, welche zuverlässig Informationen zu Übertemperaturereignissen in einem elektronischen System erfassen lassen. Eine weitere Aufgabe ist ein Herstellungsverfahren für eine derartige Vorrichtung zur Erfassung eines Übertemperaturereignisses anzugeben.

Die Aufgabe wird durch die Merkmale des unabhängigen Patentanspruchs 1 gelöst. Die auf die Vorrichtung bezogene Aufgabe wird durch die Merkmale des Patentanspruchs 6 gelöst, die auf das Herstellungsverfahren bezogene Aufgabe durch die Merkmale des Patentanspruchs 11. Ausgestaltungen der Erfindung, die einzeln oder in Kombination miteinander einsetzbar sind, sind Gegenstand der Unteransprüche.

Das erfindungsgemäße Verfahren zur Erfassung eines Temperaturereignisses in einem elektrischen System verwendet wenigstens eine Detektionsstruktur mit einem metallurgisch nicht benetzbaren Bereich zwischen elektrischen Kontakten, welche Kontakte vor einem zu erfassenden Temperaturereignis über einen Lotkörper elektrisch verbunden sind. In dem Verfahren wird ein Temperaturereignis der Schmelztemperatur des Lotmaterials oder höherer Temperatur detektiert, indem der Lotkörper während des zu erfassenden Temperaturereignisses aufschmilzt und sich dessen Lotvolumen derart von dem metallurgisch nicht benetzbaren Bereich zurückzieht, dass das Lotvolumen nach dem erfassten Temperaturereignis mehrere elektrisch voneinander getrennte Teillotkörper ausbildet, die auch nach dem Wiedererstarren keine elektrische Verbindung zwischen den Kontakten mehr ausbilden. Die Teillotkörper sind auf die Kontakte zurückgezogen.

Für das Verfahren wird demnach das Lotmaterial zweckdienlicherweise so gewählt, dass die Lottemperatur möglichst niedrig ist, z. B. unter 150°C, unter 140°C oder bevorzugt unter 130°C oder 120°C liegt. Besonders vorteilhaft können auch niedrigschmelzende Lotlegierungen mit Schmelztemperaturen unter 100°C verwendet werden. Niedrig schmelzende Lote sind beispielsweise Legierung aus Zinn und Wismut oder aus Zinn, Wismut und Silber mit einem Schmelzpunkt von um die 140°C.

Es können demnach damit Temperaturen detektiert werden, die außerhalb des für einen jeweiligen Gerätetyps spezifizierten Bereichs liegen. Dieser Temperaturbereich variiert je nach elektrischem System. Werden zur Temperaturerfassung gängige Lotlegierungen verwendet, wie sie auch zur elektrischen Anbindung von Bauteilen auf einer Baugruppe verwendet werden, gibt die Erfassung eines entsprechenden Temperaturereignisses, bei dem der Lotkörper dr Detektionsstruktur aufgeschmolzen ist an, dass auch die übrigen Lotstellen temperaturgeschädigt sind.

Dieses Verfahren hat den Vorteil, dass direkt die Eigenschaften der Lotwerkstoffe genutzt werden, um ein Temperaturereignis zu detektieren. Beim Übergang vom festen zum flüssigen Aggregatszustand, also bei Erreichen der Schmelztemperatur, verändern sich die Gleichgewichtsbedingungen, sodass der Lotkörper sich von der nicht benetzbaren Oberfläche auf die gut benetzbaren Kontaktflächen zurückzieht. Auch dessen Volumen und Oberflächenspannung werden in dem Verfahren genutzt, sodass ein Übertemperaturereignis sicher zu einer Teilung des Lotkörpers in mehrere Teillotkörper führt.

Das Verfahren hat den weiteren Vorteil, dass die so detektierten Übertemperaturereignisse sehr zuverlässig detektiert werden. Darüber hinaus ist die Veränderung der Detektionsstruktur bei einem Übertemperaturereignis nicht reversibel. Daher kommt das Verfahren ohne Ereignisspeicherung aus.

In einer vorteilhaften Ausführungsform des erfindungsgemäßen Verfahrens wird eine elektrische Auswertung mittels einer Strommessung an der wenigstens einen Detektionsstruktur vorgenommen. Zieht sich der Lotwerkstoff nach Aufschmelzen im Betrieb des elektrischen Systems und aufgrund der wirkenden Benetzungskräfte in Teilvolumina zurück, wird die elektrische Verbindung zwischen den elektrischen Kontakten der Detektionsstruktur unterbrochen. Dieser Vorgang ist demnach durch eine Strommessung an den elektrischen Kontakten auslesbar.

Beispielsweise wird diese Form der elektrischen Auswertung durch Strommessung an der wenigstens einen Detektionsstruktur nach einem vorgebbaren Betriebszeitraum des elektrischen Systems vorgenommen. Alternativ kann die Auswertung auch während des Betriebszeitraums erfolgen.

In einer besonders bevorzugten Form des Detektionsverfahrens für Temperaturereignisse, insbesondere Übertemperaturereignisse, wird nach einem Betriebszeitraum des zu bewertenden elektrischen Systems eine optische Auswertung der wenigstens einen Detektionsstruktur ausgeführt, insbesondere mittels einer automatischen optischen Inspektion (AOI). Auch eine Kombination von elektrischer und optischer Auswertung kann vorteilhaft eingesetzt werden.

In einer weiteren Ausgestaltung des erfindungsgemäßen Verfahrens erfolgt eine Temperaturfeldüberwachung mittels Auswertung mehrerer im elektrischen System verteilt vorliegender Detektionsstrukturen. Eine derartige Temperaturfeldüberwachung erfolgt insbesondere während des Betriebs des elektrischen Systems. Aber auch eine nach Feldrücklauf erfolgte Auswertung kann vorteilhaft für die Bewertung, insbesondere einer Lebensdauerabschätzung des elektrischen Systems, herangezogen werden. Ein großer Vorteil des vorgeschlagenen Verfahrens liegt darin, dass für die Temperaturereignisdetektion ein irreversibler Vorgang genutzt wird. Demnach ist keine logische Speicherung erforderlich, wie es beispielweise bei Temperatursensoren der Fall wäre.

Bei der Verwendung mehrerer Detektionsstrukturen im System werden diese insbesondere an repräsentativen Stellen angebracht. Dies können Stellen sein, die besonders empfindlich auf Temperaturstress reagieren. Dies können Stellen sein, die selbst als Übertemperaturquelle agieren können.

Für eine Temperaturfeldüberwachung werden in dem Verfahren bevorzugt die Temperaturereignis-Detektionsstrukturen über elektrische Leitungen mit einem Leitungsnetz zusammengeschlossen und ausgelesen.

Das vorgeschlagene Verfahren und die Ausführungsformen davon haben den Vorteil, relativ einfach in vorhandene Prozesse zur Überwachung und/oder Bewertung elektrischer Systeme integriert werden zu können.

Die erfindungsgemäße Temperaturereignis-Detektionsstruktur für ein elektrisches System weist auf, einen metallurgisch nicht benetzbaren Bereich zwischen elektrischen Kontakten, welche Kontakte über ein Lotvolumen elektrisch verbindbar sind. Dieses Lotvolumen liegt als Lotkörper vor und bildet eine elektrische Verbindung zwischen den elektrischen Kontakten oder das Lotvolumen liegt aufgetrennt als mehrere elektrisch voneinander getrennte Teillotkörper vor, die vom nicht benetzbaren Bereich zurückgezogen sind und an den elektrischen Kontakten anhaften.

Unter einem elektrischen System in Kontext der Erfindung wird insbesondere eine elektrische Baugruppe, ein elektrisches Bauteil oder Bauelement verstanden, beispielsweise kann es sich um leistungselektronische Baugruppen, Bauteile oder Bauelemente handeln. Besonders vorteilhaft ist die vorgeschlagene Temperaturereignis-Detektionsstruktur auf elektronischen Flachbaugruppen einsetzbar.

Die Temperaturereignis-Detektionsstruktur hat zum einen den Vorteil einer sehr niedrigen Bauhöhe, was zu geringem Bauraumbedarf führt und eine direkte Integration auf Verdrahtungsträgern ermöglicht. Zudem liegt ein weiterer Vorteil der Temperaturereignis-Detektionsstruktur darin, dass sie mittels Standardprozessen einfach in bestehende Systeme integriert werden kann. Die Detektionsstruktur wird besonders bevorzugt an einer repräsentativen Stelle für Temperaturstress im System angebracht. Zudem handelt es sich bei der erfindungsgemäßen Temperaturereignis-Detektionsstruktur um eine sehr kostengünstige Lösung für eine zuverlässige Übertemperaturereignisdetektion.

In einer vorteilhaften Ausgestaltung der Erfindung umfasst ein elektrisches System mehrere Temperaturereignis-Detektionsstrukturen, welche in dem elektrischen System verteilt vorliegen. Besonders bevorzugt liegen die Temperaturereignis-Detektionsstrukturen an repräsentativen Stellen für Temperaturstress im System, insbesondere benachbart zu sehr hitzeempfindlichen Bauteilen und/oder benachbart zu selbst temperaturabgebenden oder Übertemperaturereignis auslösenden Bauteilen im System. Dies können insbesondere Prozessoren im elektrischen System sein.

In einer weiteren vorteilhaften Ausgestaltung der Erfindung umfasst das elektrische System elektrische Leitungen, die mit den Temperaturereignis-Detektionsstrukturen verbunden sind und diese in einem Leitungsnetz zusammenschließen. Mittels derartiger Zusammenschlüsse von Detektionsstrukturen kann eine Temperaturfeldüberwachung in einem elektrischen System realisiert werden. Besonders vorteilhaft ist ein derartiges Netzwerk an Detektionsstrukturen mit elektrischen Leitungen elektrisch auslesbar.

Besonders vorteilhaft werden in der/den Temperaturereignis-Detektionsstruktur(en) des elektrischen Systems elektrische Kontakte verwendet, die metallurgisch benetzbar sind. Insbesondere weisen die elektrischen Kontakte besonders gute metallurgische Benetzungseigenschaften auf. Unter metallurgisch benetzbar ist zu verstehen, dass das Lotvolumen mit der zu bemessenden Oberfläche einen Kontaktwinkel < 90° einschließt, von besonders gut metallurgisch benetzbar spräche man ab einem Kontaktwinkel von < 80°.

Die gute Benetzbarkeit der elektrischen Kontakte hat zudem den Vorteil, dass die aufgetrennten Lotvolumina nach dem Temperaturereignis, nicht frei abperlend auf der Baugruppe wandern, sondern an den Kontakten anhaften.

Der Begriff der Benetzbarkeit wird so verwendet, dass es sich um eine partielle Benetzung handelt, d. h. der Kontaktwinkel des Lotmaterials auf den zu beurteilenden Oberflächen > 0° aber < 90° ist. Die elektrischen Kontakte sind demnach metallurgisch benetzbar, also das Lotmaterial haftet an den Kontaktoberflächen gut an.

Die metallurgisch nicht benetzbare Fläche zeichnet sich dadurch aus, dass darauf das Lotvolumen einen Kontaktwinkel >90° ausbilden würde. In diesem Fall spricht man von Nichtbenetzung. Bevorzugt wird die Oberfläche des zwischen den Kontakten liegenden Bereichs und das Lotmaterial so gewählt, dass das Lotvolumen Kontaktwinkel > 92°, insbesondere > 95° ausbildet. Aufgrund der Gleichgewichtsbedingungen bei der Lotkörperausbildung zwischen Oberflächenspannung und Benetzungskräften teilt sich der Lotkörper auf der nicht benetzbaren Fläche dann in mehrere Teilvolumina auseinander. Diese Teilvolumina ziehen sich auf die benetzbaren Kontakte zurück.

Das elektrische System umfasst in einer zweckdienlichen Ausführungsform also eine metallurgisch nicht benetzbare Fläche zwischen den elektrischen Kontakten, welche keinen weiteren Lotanschlusspunkt anbietet. Alternativ umfasst das elektrische System beziehungsweise die Temperaturereignis-Detektionsstruktur einen Zwischenbereich zwischen den elektrischen Kontakten, welcher eine metallurgisch nicht benetzbare Fläche und wenigstens einen weiteren Lotanschlusspunkt als Lotfänger umfasst, welcher weitere Lotanschlusspunkt nicht elektrisch mit den elektrischen Kontakten verbunden ist und welcher derart bemessen und positioniert ist, dass ein Abwandern der Lotperlen verhindert und gleichzeitig ein Öffnen des elektrischen Kontakts der Temperaturereignis-Detektionsstruktur gewährleistet ist.

Das erfindungsgemäße Verfahren zur Herstellung einer Temperaturereignis-Detektionsstruktur in einem elektrischen System umfasst die folgenden Schritte:
Zunächst das Bereitstellen elektrischer Kontakte in dem elektrischen System, die Bereitstellung eines metallurgisch nicht benetzbaren Bereichs zwischen wenigstens zwei elektrischen Kontakten, das Abscheiden eines Lotvolumens auf dem metallurgisch nicht benetzbaren Bereich sowie die Ausübung einer Formkontrolle während der Erstarrung des Lotvolumens zu einem Lotkörper, mittels welcher Formkontrolle der Lotkörper so gestaltet wird, dass eine elektrische Verbindung zwischen den wenigstens zwei elektrischen Kontakten hergestellt wird.

Bevorzugt werden in dem Verfahren metallurgisch benetzbare elektrische Kontakte bereitgestellt bzw. elektrische Kontakte mit metallurgisch benetzbarer Oberfläche.

In einer weiteren vorteilhaften Ausführungsform des Verfahrens wird bei der Anordnung des metallurgisch nicht benetzbaren Bereichs die Oberflächenbeschaffenheit vorhandener Substrate verwendet. Gegebenenfalls können oberflächenreinigende oder oberflächenvorbereitende Verfahren eingesetzt werden.

Bei dem Herstellungsverfahren wird bevorzugt eine Formkontrolle mittels eines Fügewerkzeugs vorgenommen. Als Fügewerkzeug werden besonders vorteilhaft Keramiken eingesetzt, welche eine nicht benetzbare Oberfläche aufweisen. Die Formkontrolle erfolgt, bis das Lotvolumen vollständig erstarrt ist. Es kommt zur Ausbildung einer Lotbrücke zwischen den elektrischen Kontakten. Das Lotvolumen wäre in seiner Ausdehnung ohne die Formkontrolle, also ohne einen äußeren Zwang, nicht geeignet, die elektrischen Kontakte zu verbinden, da es gemäß seiner Oberflächenspannung und der Benetzbarkeit der Kontaktoberflächen sowie der Benetzbarkeit des Zwischenbereichs zwischen den Kontakten, keine elektrische Verbindung zwischen den Kontakten herstellen würde. Vielmehr würde das Lotvolumen, so wie es dann im Übertemperatur-Detektionsfall passiert, in kleinere Teilvolumina zerfallen, die dann bevorzugt an den metallurgisch gut benetzbaren Kontakten anhaften.

Die Prozessierung der Teststrukturen hat den Vorteil sehr einfach und kostengünstig zu sein, einfach in die Standardprozessierung intergrierbar zu sein und demnach eine Vielzahl von Detektionsstrukturen parallel herstellbar zu machen.

Bei der Prozessierung der Teststrukturen wird insbesondere darauf geachtet, dass das Lotvolumen in seiner Ausdehnung geeignet ist, hinsichtlich Kräftegleichgewicht zwischen Benetzungskräften und Oberflächenspannung den Lotkörper auf die entsprechend erforderlichen Teilvolumina im Detektionsfall aufzuteilen.

Besonders bevorzugt ist die Herstellung miniaturisierter Detektionsstrukturen, da diese noch kostengünstiger und leichter in elektrische Systeme integrierbar sind. Weiterhin ist es vorteilhaft, Netzwerke aus den Detektionsstrukturen aufzubauen, welche über entsprechende logische Verknüpfungen von Netzabschnitten auch Informationen über die Lokalitäten der Temperaturereignisse offenbaren können. Besonders bevorzugt werden diese Detektionsstrukturen und Netzwerke daraus auf Flachbaugruppen eingesetzt.

Zweckdienlicherweise wird das Herstellungsverfahren als einer der letzten Herstellungsschritte für die Fertigung von elektrischen Systemen ausgeführt, um die Detektionsstrukturen nicht schon während der Fertigung des elektrischen Systems Temperaturstress auszusetzen. Insbesondere wenn besonders niedrigschmelzende Lote eingesetzt werden, werden die Temperaturereignis-Detektionsstrukturen auf fertige elektrische Systeme, insbesondere fertig bestückte Baugruppen aufgebracht.

Weitere Merkmale, Eigenschaften und Vorteile der vorliegenden Erfindung ergeben sich aus der nachfolgenden Beschreibung unter Bezugnahme auf die beiliegenden Figuren. In den Ausführungsbeispielen und Figuren können gleiche oder gleichwirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente zur besseren Darstellbarkeit und/oder zum besseren Verständnis im Verhältnis größer dimensioniert dargestellt sein. In den Figuren zeigen schematisch:
- Figur 1: einen Querschnitt durch eine Temperaturereignis-Detektionsstruktur det während des Fügeprozesses,
- Figur 2: einen Querschnitt durch eine Temperaturereignis-Detektionsstruktur det_c im geschlossenen Zustand, d. h. eine Lotbrücke 3 ausbildend zwischen den Kontakten 4 und
- Figur 3: einen Querschnitt durch eine Temperaturereignis-Detektionsstruktur det_o im offenen Zustand nach erfolgtem Temperaturereignis und Auseinanderteilung des Lotvolumens in Teilvolumina 3`.

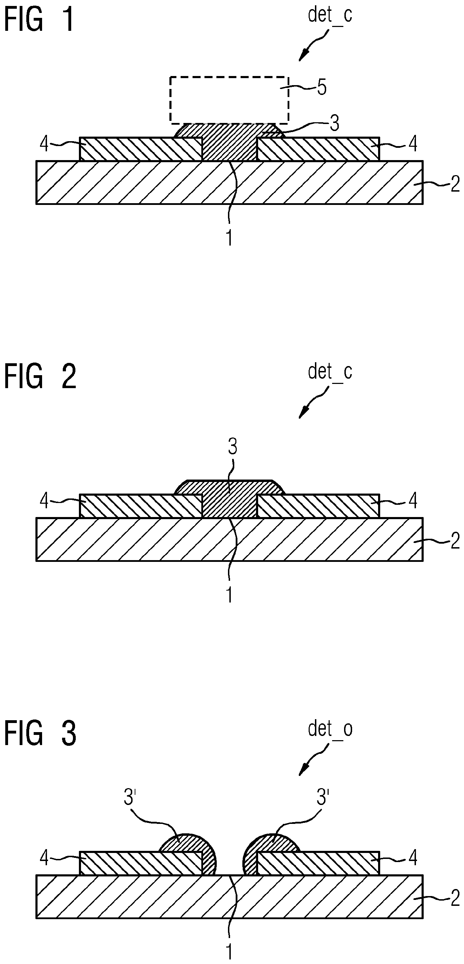

In der Figur 1 ist zunächst ein Substrat 2 gezeigt, welches eine Oberfläche einer Leiterplatte sein kann, ein Chip oder eine zweckdienliche Oberfläche innerhalb eines elektrischen Systems. Dieses Substrat 2 weist einen Bereich 1 auf, also einen Oberflächenabschnitt, welcher metallurgisch nicht benetzbar ist. In den meisten Fällen kann dieser Bereich in den vorhandenen Strukturen elektrischer Systeme vorgefunden und genutzt werden. Geeignete nicht metallurgisch benetzbare Oberflächen weisen z. B. Substrate auf, umfassend Lötstoppmaske, Oberflächen des Basismaterials der Leiterplatte, insbesondere Verbundwerkstoffe aus Epoxid und Glasfaser und/oder Keramiken, und/oder PTFE (insbesondere Teflon).

Des Weiteren ist in der Figur 1 ein Fügewerkzeug 5 gezeigt. Mittels dieses Fügewerkzeug wird während des Erstarrungsprozesses des Lotkörpers 3 ein äußerer Zwang ausgeübt, sodass sich das Lotvolumen 3 auf die nicht benetzbare Fläche 1 legt und eine Lotbrücke zwischen den Kontakten 4 ausbildet. Die elektrischen Kontakte oder auch Terminals 4 genannt, weisen zweckdienlicherweise eine benetzbare Oberfläche auf.

Als Fügewerkzeug werden besonders bevorzugt keramische Werkstoffe verwendet, diese sind nicht metallurgisch benetzbar und besonders temperatur- und formstabil.

In der Figur 2 ist dann eine geschlossene Temperaturereignis-Detektionsstruktur det_c gezeigt. Hier wird die sehr flache Bauhöhe deutlich. Die Struktur det_c aus einer Lotbrücke 3 zwischen zwei Terminals 4 über einen nicht benetzbaren Zwischenterminalbereich 1 ist ein miniaturisierter und dennoch höchst zuverlässiger Temperaturereignis-Detektor, welcher dank seiner geringen Baugröße in einer Vielzahl hergestellt und gezielt verteilt in elektrischen Systemen unterschiedlichster Art eingesetzt werden kann.

Die Figur 3 schließlich zeigt eine geöffnete Temperaturereignis-Detektionsstruktur det_o: Das Lotvolumen ist in zwei Teilvolumina 3` auf die Terminals 4 zurückgezogen. Beim Aufschmelzen des Volumens wirken Benetzungskräfte zwischen den unterschiedlichen Oberflächen des Zwischenterminalbereichs 1, der Terminals 4 sowie die Oberflächenspannung des Lotmaterials, sodass der elektrische Kontakt zwischen den Terminals 4 unterbrochen wird. Diese Detektionsstruktur det ist demnach elektrisch auslesbar aber auch optisch auslesbar, insbesondere mittels einer automatischen optischen Inspektion.

Es wird also, zusammengefasst, ein Verfahren und eine Detektionsstruktur zur Erfassung eines Temperaturereignisses in einem elektrischen System vorgeschlagen. Mittels wenigstens einer Temperaturereignis-Detektionsstruktur det mit einem metallurgisch nicht benetzbaren Bereich 1 zwischen elektrischen Kontakten 4, welche Kontakte 4 vor einem zu erfassenden Temperaturereignis über einen Lotkörper 3 elektrisch verbunden sind det_c und welcher Lotkörper 3 während eines zu erfassenden Temperaturereignis aufschmilzt und sich dessen Lotvolumen derart von dem metallurgisch nicht benetzbaren Bereich 1 zurück zieht, dass es nach einem erfassten Temperaturereignis mehrere elektrisch voneinander getrennte Teillotkörper 3' ausbildet, können kostengünstig und systemintegriert, zuverlässig Übertemperaturereignisse erfasst werden. Die geschlossenen, unbelasteten Temperaturereignis-Detektionsstruktur(en) det werden realisiert durch Ausübung einer Formkontrolle während der Erstarrung des Lotvolumens zu einem Lotkörper 3, so dass der Lotkörper eine elektrische Verbindung zwischen wenigstens zwei elektrischen Kontakten 4 herstellt.

### Bezugszeichenliste:

- 1: Metallurgisch nicht benetzbarer Zwischenterminalbereich
- 2: Substrat, Oberfläche, Leiterplatte
- 3: Lotkörper mit Schmelztemperatur (Ts)
- 3': Lot
- 4: Terminals, elektrische Kontakte
- 5: Fügewerkzeug (für Fügung unter Zwang) z.B. keramischer Werkstoff, nicht benetzbar, temperatur- und formstabil
- det: Temperaturereignis-Detektionsstruktur
- _c/_o: closed/open

## Patentansprüche

1. Verfahren zur Erfassung eines Temperaturereignisses in einem elektrischen System mittels wenigstens einer Detektionsstruktur mit einem metallurgisch nicht benetzbaren Bereich (1) zwischen elektrischen Kontakten (4), welche Kontakte (4) vor einem zu erfassenden Temperaturereignis über einen Lotkörper (3) elektrisch verbunden sind (det_c) und welcher Lotkörper (3) während eines zu erfassenden Temperaturereignis aufschmilzt und sich dessen Lotvolumen derart von dem metallurgisch nicht benetzbaren Bereich (1) zurück zieht, dass es nach einem erfassten Temperaturereignis mehrere elektrisch voneinander getrennte Teillotkörper (3`) ausbildet.

2. Verfahren nach Anspruch 1, bei dem eine elektrische Auswertung mittels Strommessung an der wenigstens einen Detektionsstruktur (det) erfolgt.

3. Verfahren nach Anspruch 1 oder 2, bei dem nach einem Betriebszeitraum des elektrischen Systems eine elektrische Auswertung der wenigstens einen Detektionsstruktur (det) erfolgt.

4. Verfahren nach einem der Ansprüche 1 bis 3, bei dem nach einem Betriebszeitraum des elektrischen Systems eine optische Auswertung der wenigstens einen Detektionsstruktur (det) erfolgt, insbesondere mittels einer AOI (Automatische optische Inspektion).

5. Verfahren nach einem der Ansprüche 1 bis 4, bei dem eine Temperaturfeldüberwachung mittels Auswertung mehrerer im elektrischen System verteilt vorliegenden Detektionsstrukturen (det) erfolgt, insbesondere während eines Betriebszeitraums des elektrischen Systems.

6. Temperaturereignis-Detektionsstruktur (det) für ein elektrisches System, aufweisend einen metallurgisch nicht benetzbaren Bereich (1) zwischen elektrischen Kontakten (4), welche Kontakte (4) über ein Lotvolumen elektrisch verbindbar sind, welches Lotvolumen als Lotkörper (3) eine elektrische Verbindung zwischen den elektrischen Kontakten (4) ausbildet oder aufgetrennt als mehrere elektrisch voneinander getrennte Teillotkörper (3`) vorliegt.

7. Elektrisches System umfassend mehrere Temperaturereignis-Detektionsstrukturen (det) nach Anspruch 6, welche im elektrischen System verteilt vorliegen.

8. Elektrisches System nach Anspruch 7, umfassend elektrische Leitungen, die mit den Temperaturereignis-Detektionsstrukturen (det) verbunden sind und diese in einem Leitungsnetz zusammenschließen.

9. Elektrisches System nach einem der Ansprüche 6 bis 8, wobei die elektrischen Kontakte (4) metallurgisch benetzbar sind.

10. Elektrisches System nach einem der Ansprüche 6 bis 9, wobei der metallurgisch nicht benetzbare Bereich (1) einen Kontaktwinkel zum Lotmaterial von größer 90° aufweist.

11. Verfahren zur Herstellung einer Temperaturereignis-Detektionsstruktur (det) in einem elektrischen System, umfassend die Schritte:
- Bereitstellen elektrischer Kontakte (4) in einem elektrischen System,
- Bereitstellung eines metallurgisch nicht benetzbaren Bereichs (1) zwischen wenigstens zwei elektrischen Kontakten (4),
- Abscheiden eines Lotvolumens auf dem metallurgisch nicht benetzbaren Bereich (1) und
- Ausübung einer Formkontrolle während der Erstarrung des Lotvolumens zu einem Lotkörper (3), so dass der Lotkörper eine elektrische Verbindung zwischen wenigstens zwei elektrischen Kontakten (4) herstellt.

12. Verfahren nach Anspruch 11, wobei metallurgisch benetzbare elektrische Kontakte (4) bereitgestellt werden.

13. Verfahren nach Anspruch 11 oder 12, wobei die Bereitstellung des metallurgisch nicht benetzbaren Bereichs (1) mittels Oberflächenreinigung und/oder Vorbehandlung erfolgt.

14. Verfahren nach einem der Ansprüche 11 bis 13, wobei die Ausübung der Formkontrolle mittels eines Fügewerkzeugs (5) erfolgt.

15. Verfahren nach Anspruch 14, wobei ein keramisches Fügewerkzeug (5) verwendet wird.
